# EUROPEAN PATENT APPLICATION

(11) **EP 1 505 644 A2**
(43) Date of publication of application: **09.02.2005**
(21) Application number: 04076970.5
(22) Date of filing: 07.07.2004
(51) Int. Cl.: H01L 23/433

(54) **Thermally enhanced electronic module**

(30) Priority: 21.07.2003 US 623783
(71) Applicant: Delphi Technologies, Inc., Troy, MI 48007 (US)
(72) Inventor: Oman, Todd P, Greentown, IN 46936 (US); Myers, Bruce A, Kokomo, IN 46901 (US); Brandenburg, Scott D, Kokomo, IN 46902 (US)
(74) Representative: Denton, Michael John

(57) **Abstract**

A thermally enhanced electronic module (100) includes a thermally conductive case (112), a self-aligning thermally conductive heat sink (114) and a die (116). The case (112) includes a pivot area (140) with a first shape formed into the case (112) for receiving a first portion of the heat sink (114) and a first portion of the heat sink (114) has a second shape that is complementary to the first shape. The die (116) includes a first surface and a second surface opposite the first surface. The die (116) is mounted to a substrate (124) with the first surface of the die (116) facing the substrate (124) and the second surface of the die (116) is in thermal contact with the heat sink (114).

## Description

### Technical Field

The present invention is generally directed to an electronic module and, more specifically, to a thermally enhanced electronic module that includes a self-aligning pedestal heat sink.

### Background of the Invention

Various power devices, such as field effect transistors (FETs) and insulated gate bipolar transistors (IGBTs), require relatively efficient heat sinking to eliminate performance problems attributable to thermal limitations. Historically, these devices have been packaged in, for example, TO-220, DPAK or D²PAK type semiconductor packages with the devices being mounted to a copper slug and then overmolded. Such semiconductor packages have then been mounted to a highly conductive substrate or heat rail, which provides for one-sided heat sinking.

An alternative method has mounted a die directly to a substrate with a back of the die being coated with a thermal grease to engage a fixed pedestal heat sink that is fabricated as part of a case. Dual-sided heat sinking in this manner generally reduced thermal resistance by an order of magnitude. In such a configuration, it is highly desirable to minimize the gap between the pedestal and the die as the thermal grease positioned in the gap between the pedestal and the die has generally had significantly higher thermal resistance than the other components of the thermal structure

In one such electronic module, a relatively thin (0.031 inch) flexible laminate substrate was used to improve alignment of a die with a fixed pedestal heat sink. Due to the fact that the substrate had limited compliance, the force applied to solder joints of the die was frequently asymmetrical. This asymmetrical force has tended to increase the variability of solder joint reliability. Further, the variation in the gap between the die and the fixed pedestal heat sink has resulted in a variable thermal performance between similar assemblies. Additionally, utilizing a fixed pedestal heat sink limits the rigidity of the substrate that can be used and, thus, makes solder joints that attach a die to a substrate more vulnerable to cracking prior to underfill.

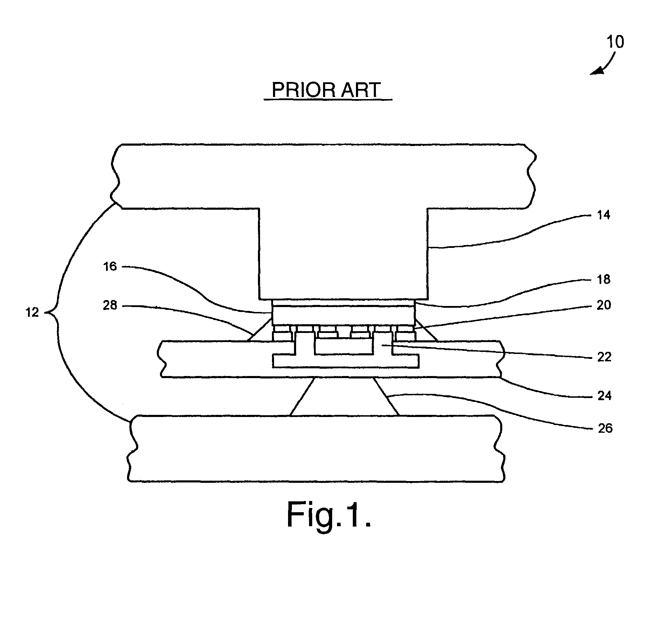

Fig. 1 depicts a partial cross-section of a typical prior art electronic module 10 that includes a case 12 having an upper half and a lower half. The upper half of the case 12 includes an integrated fixed pedestal heat sink 14, which is in thermal contact with a flip chip 16. As is shown, a thermal grease 18 is located at the interface between the heat sink 14 and the flip chip 16. As shown, the flip chip 16 includes a number of contacts 20 that are soldered to traces 22 formed on a substrate 24. The substrate 24 is mounted to the lower portion of the case 12 via a standoff 26, such as an elastomer. The module 10 requires relatively tight tolerances for flip chip 16 tilt and substrate 24 warpage and requires that the substrate 24 be relatively flexible to allow the flip chip 16 to align to the fixed pedestal heat sink 14, which places solder joints at risk to crack prior to stabilization. An underfill 28 stabilizes the flip chip 16. As previously discussed, due to uneven application of force to the flip chip 16, the reliability of the flip chip 16 is somewhat variable as asymmetrical loads on the solder joints of the flip chip 16 can result in failure of the solder joints.

What is needed is an improved technique for conducting heat away from an electronic module.

### Summary of the Invention

An embodiment of the present invention is directed to a thermally enhanced electronic module that includes a thermally conductive case, a self-aligning thermally conductive heat sink and a die. The case includes a pivot area with a first shape formed into the case for receiving a first portion of the heat sink and a first portion of the heat sink has a second shape that is complementary to the first shape. The die includes a first surface and a second surface opposite the first surface. The die is mounted to a substrate with the first surface of the die facing the substrate and the second surface of the die is in thermal contact with the heat sink.

According to another embodiment of the present invention, the substrate is a ceramic substrate. According to still another embodiment of the present invention, a thermally conductive film is located between the die and the heat sink. According to still another embodiment of the present invention, one of a thermally conductive grease and a thermally conductive adhesive are located between the case and the heat sink. In yet another embodiment of the present invention, the first shape of the pivot area is concave and the second shape of the heat sink is convex.

These and other features, advantages and objects of the present invention will be further understood and appreciated by those skilled in the art by reference to the following specification, claims and appended drawings.

### Brief Description of the Drawings

The present invention will now be described, by way of example, with reference to the accompanying drawings, in which:
Fig. 1 is a cross-sectional view of an electronic module according to the prior art;
Fig. 2 is a cross-sectional view of an electronic module according to the present invention;
Figs. 3 and 4 are cross-sectional views of a self-aligning pedestal heat sink according to different embodiments of the present invention;
Figs. 5 and 6 are views of a die in contact with a self-aligning pedestal heat sink according to different embodiments of the present invention; and
Fig. 7 is a cross-sectional view of an electronic assembly including a plurality of electronic devices that utilize self-aligning pedestal heat sinks according to one embodiment of the present invention.

### Description of the Preferred Embodiments

According to the present invention, a self-aligning pedestal heat sink that may be utilized for various power devices is disclosed. Implementing such a self-aligning pedestal heat sink allows for the use of relatively rigid substrates, such as relatively thick (e.g., 0.062 inch) laminates, ceramics, Al²O³, aluminum nitride (AIN), silicon nitride (SiN) and low temperature cofired ceramics (LTCCs). Thus, implementing a self-aligning pedestal heat sink allows for relatively rigid substrates or components with more tilt than a compliant substrate can accommodate. This is especially advantageous with devices, such as power devices, with die having thick solder joints and packaged parts that have increased tilt and height variation.

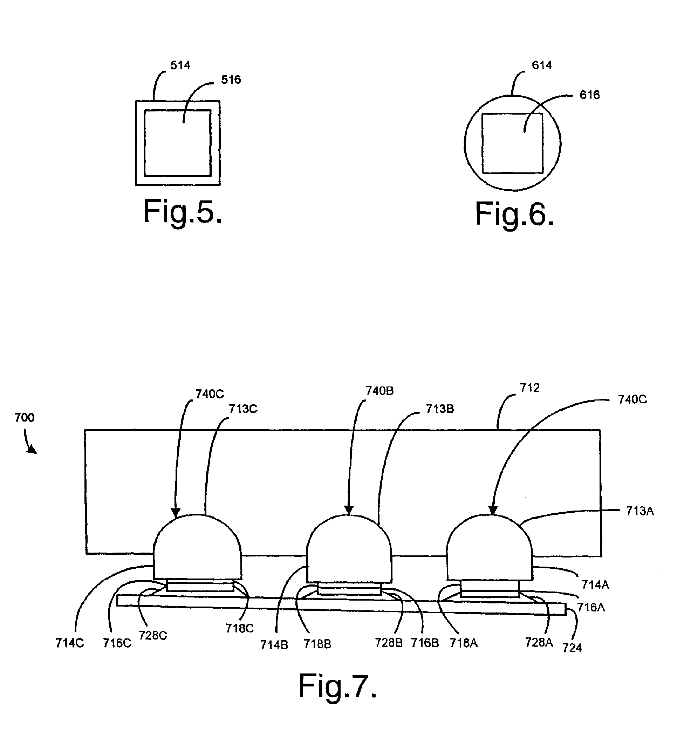

According to one embodiment of the present invention, a self-aligning pedestal heat sink includes a semi-spherical concave pivot area formed in a case that receives a convex pedestal that acts as a self-aligning pedestal heat sink. The pivot area decouples the pedestal mechanically but maintains a high quality thermal path with a relatively large surface area. Thermal conductivity can be enhanced through the application of a thermal grease or adhesive at the interface to fill the relatively small air gap between the case and the heat sink. It should be appreciated that the depth of the pivot area can be varied to handle different case thicknesses. Through the use of a round pedestal (see Fig. 6), registration requirements to the die may be eliminated. However, in situations where a square rectangular pedestal (see Fig. 5) is desirable, it may be matched to the size of the die to provide clearance of other components.

Compensation for variation in component height can be addressed through the use of an advanced thermal transfer adhesive (ATTA) film. Typically, such a film is a thermoplastic epoxy with thermally conductive carbon fibers aligned perpendicular to the length and width of the film for efficient thermal conductivity at various levels of compression. The use of an ATTA film usually improves thermal performance by a factor of two over assemblies that utilize thermal grease. A suitable ATTA film is manufactured and made commercially available by Btech Corporation (Part No. ATTA-LP-1).

As previously mentioned, a self-aligning heat pedestal facilitates the use of rigid substrates, which can help to eliminate cracked bumps due to substrate deflection during the assembly process prior to underfill. Further, utilization of a self-aligning pedestal heat sink improves reliability by symmetrically applying a contact load to the solder joints and accommodates packaged and high power devices with thick solder joints, which usually have more tilt and height variation. Such a self-aligning pedestal heat sink may be fabricated independently from the case out of materials that have superior thermal characteristics, which may serve to boost suppression of thermal transients that are typically localized on the die.

Further, self-aligning pedestal heat sinks may be fabricated more economically in situations where electrical isolation is required for the heat sink by applying a thin layer of non-conductive material, such as a sheet of silicon nitride (SiN) or a deposited diamond-like carbon (DLC) film. Further, in assemblies utilizing self-aligning heat sink pedestals, machining of pedestal surfaces, which is required to prevent mechanical damage to a bare die in assemblies employing pedestal heat sinks, can be performed on the pedestal independent of the case fabrication or completely eliminated if using a thermally conductive film instead of thermal grease. Finally, a self-aligning pedestal heat sink according to the present invention facilitates easier implementation and more economical packaging of assemblies whose dies vary in thickness. That is, variations in die thickness can be accommodated by pedestal modification, obviating the need for modification of the case.

A self-aligning pedestal heat sink is particularly advantageous when implemented in electronic modules that include devices, such as field effect transistors (FETs), insulated gate bipolar transistors (IGBTs), power flip chips and power packages. Such devices may be utilized in DC to AC converters, electronic power steering modules, electric vehicle (EV)/hybrid modules, power modules and injector driver modules. Electronic modules that include a self-aligning pedestal heat sink generally provide a higher level of system performance and eliminate line-pull and warranty returns for cracked solder joints generated during assembly. Assemblies incorporating self-aligning pedestal heat sinks typically have improved product life as solder joint loads are more distributed.

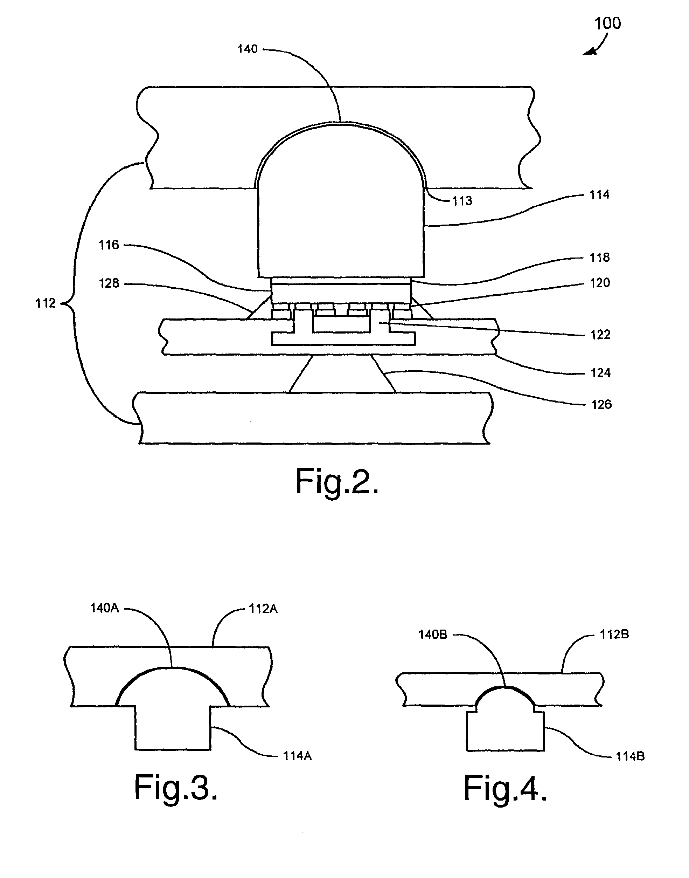

Fig. 2 depicts a thermally enhanced electronic module 100 according to one embodiment of the present invention in partial cross-section. As with the electronic module 10 of Fig. 1, the electronic module 100 includes a case 112, including an upper portion and a lower portion. However, as is shown in Fig. 2, the upper portion of the case 112 includes an aperture 140 that has a first shape for receiving a first portion of a self-aligning thermally conductive heat sink 114. Positioned between the interface of the upper portion of the case 112 and the heat sink 114 is a thermally conductive interface, e.g., a conductive grease and/or a thermally conductive adhesive, 113. The grease/adhesive 113 serves to increase the thermal conductivity between the upper portion of the case 112 and the heat sink 114. A lower portion of the heat sink 114 is in thermal contact with a die 116. A thermal film 118 is located at the interface between the die 116 and the heat sink 114.

A second surface of the die 116, which is opposite the first surface of the die 116, includes a plurality of contacts 120, which are soldered to traces 122 formed on substrate 124. As with the electronic module 10, the electronic module 100 includes a standoff 126, e.g., an elastomer standoff, that is positioned between the substrate 124 and the lower portion of the case 112.

Fig. 3 shows a partial cross-section of an upper portion of a case 112A, which is in thermal contact with a self-aligning pedestal heat sink 114A. In this particular situation, the case 112A is relatively thick and includes a large pivot area 140A. As is shown in Fig. 4, an upper portion of a relatively thin case 112B includes an aperture 140B for receiving a self-aligning pedestal heat sink 114B. It should be appreciated that, from the cross-section of Fig. 4, the aperture 140B has a relatively small pivot area. Fig. 5 shows a die side view of a die 516 mounted on a square pedestal 514 and Fig. 6 shows a die side view of a die 616 mounted on a round pedestal 614.

Fig. 7 depicts a thermally enhanced electronic module 700 that includes three devices 716A, 716B and 716C mounted to a substrate 724. Each of the devices 716A, 716B and 716C have an associated self-aligning thermally conductive heat sink 714A, 714B and 714C, respectively. Fig. 7 also shows variation in chip to pedestal z-axis alignment, which the ATTA film addresses. That is, the ATTA film takes up the variation. As shown in Fig. 7, thermal interfaces 713A, 713B and 713C, e.g., thermal grease and/or thermal adhesives, provide for increased thermal conductivity between the self-aligning thermally conductive heat sinks 714A, 714B and 714C and areas 740A, 740B and 740C, respectively, formed in case 712. Thermal interfaces 718A, 718B and 718C, e.g., thermal grease and/or thermal adhesives, provide for increased thermal conductivity between the devices 716A, 716B and 716C and the heat sinks 714A, 714B and 714C, respectively. Underfills 728A, 728B and 728C support the devices 716A, 716B and 716C, respectively, and tend to prevent solder joint cracks. It should be appreciated that electronic modules, including self-aligning thermally conductive heat sinks according to the present invention may include greater than or less than three self-aligning thermally conductive heat sinks in thermal contact with various devices mounted to a substrate.

Accordingly, a thermally enhanced electronic module that includes a self-aligning pedestal heat sink has been described herein. Such an electronic module can utilize relatively rigid substrates and/or allows for components with more tilt than a compliant substrate can accommodate. By utilizing thermoplastic epoxy carbon fiber materials, such as ATTA films, as thermal interfaces, variations, such as component height, board warpage and z-axis tolerance stack-ups, can be accommodated. A thermally enhanced electronic module with a self-aligning thermally conductive heat sink can be advantageously implemented within an automotive environment in various assemblies, such as DC to AC converters, electronic power steering modules, EV/hybrid modules, power modules and injector modules.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A thermally enhanced electronic module (100), comprising:
a thermally conductive case (112);
a self-aligning thermally conductive heat sink (114) , wherein the case (112) includes a pivot area (140) with a first shape formed into the case (112) for receiving a first portion of the heat sink (114), and wherein the first portion of the heat sink (114) has a second shape that is complimentary to the first shape; and
a die (116) with a first surface and a second surface opposite the first surface, wherein the die (116) is mounted to a substrate (124) with the first surface of the die (116) facing the substrate (124), and wherein the second surface of the die (116) is in thermal contact with the heat sink (114).

2. The module (100) of claim 1, wherein the substrate (124) is a ceramic substrate.

3. The module (100) of claim 1, further including:
a thermally conductive film (118) located between the die (116) and the heat sink (114).

4. The module (100) of claim 1, further including:
one of a thermally conductive grease and a thermally conductive adhesive (113) located between the case (112) and the heat sink (114).

5. The module (100) of claim 1, wherein the first shape of the pivot area (140) is concave and the second shape of the heat sink (114) is convex.

6. The module (100) of claim 1, wherein the die (116) includes at least one of a field effect transistor (FET), an insulated gate bipolar transistor (IGBT), a power flip chip and a power package.

7. The module (100) of claim 1, wherein the substrate (124) is one of a laminate substrate, a ceramic substrate, an aluminum oxide substrate, a silicon nitride substrate and a low temperature co-fired ceramic substrate.

8. A thermally enhanced automotive electronic module (100), comprising:
a thermally conductive metal case (112);
a self-aligning thermally conductive heat sink (114), wherein the case (112) includes a pivot area (140) with a first shape formed into the case (112) for receiving a first portion of the heat sink (114), and wherein the first portion of the heat sink (114) has a second shape that is complimentary to the first shape; and
a die (116) with a first surface and a second surface opposite the first surface, wherein the die (116) is mounted to a substrate (124) with the first surface of the die (116) facing the substrate (124), and wherein the second surface of the die (116) is in thermal contact with the heat sink (114).

9. The module (100) of claim 8, wherein the substrate (124) is a ceramic substrate.

10. The module (100) of claim 8, further including:
a thermally conductive film (118) located between the die (116) and the heat sink (114).

11. The module (100) of claim 8, further including:
one of a thermally conductive grease and a thermally conductive adhesive (113) located between the case (112) and the heat sink (114).

12. The module (100) of claim 8, wherein the first shape of the pivot area (140) is concave and the second shape of the heat sink (114) is convex.

13. The module (100) of claim 8, wherein the die (116) includes at least one of a field effect transistor (FET), an insulated gate bipolar transistor (IGBT), a power flip chip and a power package.

14. The module (100) of claim 8, wherein the substrate (124) is one of a laminate substrate, a ceramic substrate, an aluminum oxide substrate, a silicon nitride substrate and a low temperature co-fired ceramic substrate.

15. A method for manufacturing a thermally enhanced electronic module (100), comprising the steps of:
forming a pivot area (140) into an inner surface of a thermally conductive case (112);
positioning a substrate (124) including a die (116) within the thermally conductive case (112), wherein the die (116) includes a first surface and a second surface opposite the first surface, and wherein the die (116) is mounted to the substrate (124) with the first surface of the die (116) facing the substrate (124); and
positioning a portion of a self-aligning thermally conductive heat sink (114) into the pivot area (140) and in thermal contact with the second surface of the die (116) and the case (112).

16. The method of claim 15, further including the step of:
providing a thermally conductive film (118) between the die (116) and the heat sink (114).

17. The method of claim 15, further including the step of:
providing one of a thermally conductive grease and a thermally conductive adhesive (113) between the case (112) and the heat sink (114).

18. The method of claim 15, wherein a shape of the pivot area (140) is concave and a shape of the heat sink (114) that positioned in the pivot area (140) is convex.

19. The method of claim 15, wherein the die (116) includes at least one of a field effect transistor (FET), an insulated gate bipolar transistor (IGBT), a power flip chip and a power package.

20. The method of claim 15, wherein the substrate (124) is one of a laminate substrate, a ceramic substrate, an aluminum oxide substrate, a silicon nitride substrate and a low temperature co-fired ceramic substrate.
